# EUROPÄISCHE PATENTSCHRIFT

(11) **EP 2 984 680 B1**
(45) Veröffentlichungstag und Bekanntmachung des Hinweises auf die Patenterteilung: **08.04.2020**
(21) Anmeldenummer: 14717118.5
(22) Anmeldetag: 08.04.2014
(51) Int. Cl.: H01L 23/492, H01L 25/07, H01L 23/051

(54) **LEISTUNGSHALBLEITERMODUL**
POWER SEMICONDUCTOR MODULE
MODULE SEMI-CONDUCTEUR DE PUISSANCE

(30) Priorität: 09.04.2013 EP 13162942
(43) Veröffentlichungstag der Anmeldung: 17.02.2016
(73) Patentinhaber: ABB Power Grids Switzerland AG, 5400 Baden (CH)
(72) Erfinder: HARTMANN, Samuel, CH-5603 Staufen (CH); DUGAL, Franc, CH-8121 Benglen (CH); EKWALL, Olle, S-77143 Ludvika (SE); DORÉ, Erik, S-77134 Ludvika (SE)
(74) Vertreter: Qip Patentanwälte Dr. Kuehn & Partner mbB
(86) Internationale Anmeldenummer: PCT/EP2014/057012
(87) Internationale Veröffentlichungsnummer: WO 2014/166928

(56) Entgegenhaltungen:
- EP-A1- 1 403 923
- EP-A2- 0 645 814
- EP-A2- 0 989 611
- WO-A2-2012/107482
- DE-A1- 19 644 009
- US-A- 5 512 790
- US-B1- 6 426 561

## Beschreibung

Die vorliegende Erfindung betrifft ein Leistungshalbleitermodul gemäss dem Oberbegriff von Anspruch 1.

Ein derartiges Leistungshalbleitermodul ist aus der DE 196 44 009 A1 bekannt.

Weitere Leistungshalbleitermodule sind auch dem Stand der Technik ebenfalls bekannt und beispielsweise in EP 0 645 814 A2, EP 0 989 611 A2, US 6426561, EP 1 403 923 A1 oder WO 2012/107482 A2 beschrieben. Diese Module werden beispielsweise für Stromrichteranlagen für die Hochspannungs-Gleichstrom-Übertragung verwendet.

Typischerweise wird ein Leistungshalbleitermodul minimal mit mehr als 500 V und mit mehr als 1 kA im Betrieb belastet. Bei Anwendung der Leistungshalbleitermodule in einer Stromrichteranlage für die Hochspannungs-Gleichstrom-Übertragung werden die Leistungshalbleitermodule in Serie geschaltet um die notwendige Sperrspannung zu erreichen.

Typischerweise werden zwischen 100 und 1000 Leistungshalbleitermodule in Serie geschaltet.

Weiter werden derartige Leistungshalbleitermodule auch für statische Blindleistungskompensatoren verwendet, welche auf Englisch als "static VAR compensator" bezeichnet werden.

Bei den bekannten Leistungshalbleitermodulen erweist es sich als nachteilig, dass aufgrund des magnetischen Feldes, welche ein durch die Leistungshalbleitermodule fliessender Strom erzeugt, die in den Leistungshalbleitermodulen angeordneten Leistungshalbleiterbauelemente ungleichmässig belastet werden. Dies kann insbesondere zu einer Überlastung einzelner Leistungshalbleiterbauelemente führen. Eine Überlastung eines Leistungshalbleiterbauelementes hat den Ausfall des Moduls zur Folge, in welchem das überlastete Leistungshalbleiterbauelement angeordnet ist.

Aufgabe der vorliegenden Erfindung ist es, ein Leistungshalbleitermodul anzugeben, in welchem die Leistungshalbleiterbauelemente möglichst gleichmässig belastet sind.

Diese Aufgabe wird erfindungsgemäss durch ein Leistungshalbleitermodul gemäss Anspruch 1 gelöst. In den abhängigen Ansprüchen sind vorteilhafte Weiterbildungen der Erfindung angegeben.

Das erfindungsgemässe Leistungshalbleitermodul weist eine erste Hauptelektrode, eine zweite Hauptelektrode und einen Kontrollanschluss auf. Weiter weist das Leistungshalbleitermodul steuerbare Leistungshalbleiterbauelemente auf, welche zwischen der ersten Hauptelektrode und der zweiten Hauptelektrode angeordnet sind, wobei jedes steuerbare Leistungshalbleiterbauelement eine erste Elektrode, eine zweite Elektrode und eine Kontrollelektrode aufweist und die erste Elektrode jedes steuerbaren Leistungshalbleiterbauelementes mit der ersten Hauptelektrode, die zweite Elektrode jedes steuerbaren Leistungshalbleiterbauelementes mit der zweiten Hauptelektrode und die Kontrollelektrode jedes steuerbaren Leistungshalbleiterbauelementes mit dem Kontrollanschluss elektrisch verbunden ist. Zumindest ein Teil der steuerbaren Leistungshalbleiterbauelemente ist in mehreren Ringanordnungen angeordnet, wobei die steuerbaren Leistungshalbleiterbauelemente der jeweiligen Ringanordnung zumindest annähernd entlang einer ersten Kreislinie der jeweiligen Ringanordnung angeordnet sind und eine Kontrollleiterbahn der jeweiligen Ringanordnung auf der ersten Hauptelektrode angeordnet ist, wobei die Kontrolleiterbahn der jeweiligen Ringanordnung zumindest annähernd entlang einer zweiten Kreislinie der jeweiligen Ringanordnung verläuft, und die zweite Kreislinie der jeweiligen Ringanordnung konzentrisch und ausserhalb zur ersten Kreislinie der jeweiligen Ringanordnung verläuft, wobei die Kontrollelektrode jedes steuerbaren Leistungshalbleiterbauelementes der jeweiligen Ringanordnung über eine elektrische Verbindung mit der Kontrollleiterbahn der jeweiligen Ringanordnung verbunden ist und die Kontrolleiterbahn der jeweiligen Ringanordnung über eine weitere elektrische Verbindung mit dem Kontrollanschluss verbunden ist.

Erfindungsgemäss sind die Leistungshalbleiterbauelemente in mehreren Ringanordnungen angeordnet. Durch die Ringanordnungen beziehungsweise durch die Anordnung der steuerbaren Leistungshalbleiterbauelemente zumindest annähernd entlang einer Kreislinie, sind die Leistungshalbleiterbauelemente der jeweiligen Ringanordnung im Wesentlichen einem gleichen oder zumindest ähnlichen Magnetfeld während des Betriebes ausgesetzt. Weiter verläuft die Kontrollleiterbahn der jeweiligen Ringanordnung zumindest annähernd entlang einer zweiten Kreislinie, wobei die zweite Kreislinie konzentrisch und ausserhalb zur ersten Kreislinie verläuft. Somit koppelt in jede Leiterschleife, welche den Kontrollanschluss, die Kontrollelektrode des jeweiligen Leistungshalbleiterbauelements, die zweite Elektrode des jeweiligen Leistungshalbleiterbauelements und die zweite Hauptelektrode aufweist, ein zumindest annähernd ähnliches Magnetfeld in jede der Leiterschleifen ein, womit das Schaltverhalten der Leistungshalbleiterbauelemente der jeweiligen Ringanordnung durch das Magnetfeld zumindest annähern gleich beeinflusst wird.

Im Vergleich zu einer zweiten Kreislinie, die innerhalb der ersten Kreislinie liegen würde, führt die erfindungsgemässe Ausführungsform wegen der Einkopplung des Magnetfeldes in die oben definierten Leiterschleifen zu einem verzögerten Schaltverhalten jedes Leistungshalbleiterbauelementes. Dies wirkt sich insbesondere günstig auf das Kurzschlussverhalten des Leistungshalbleitermoduls aus.

Durch die mehreren Ringanordnungen wird eine optimale Ausnutzung des Platzes ermöglicht beziehungsweise es wird eine hohe Leistungsdichte erzielt.

Gemäss einer bevorzugten Ausführungsform des Leistungshalbleitermoduls ist die erste Kreislinie durch ein erstes Vieleck und die dazugehörige zweite Kreislinie durch ein zweites Vieleck mit derselben Anzahl Ecken wie das erste Vieleck angenähert, wobei die Ecken des ersten Vieleckes auf die Ecken des zweiten Vieleckes ausgerichtet sind.

Durch diese Ausführungsform ist insbesondere eine wirtschaftliche Produktion der Leistungshalbleitermodule möglich, wobei Abweichungen von der Kreissymmetrie auf das Schaltverhalten gering ausfallen.

Gemäss einer bevorzugten Ausführungsform des Leistungshalbleitermoduls weist das Leistungshalbleitermodul aktive Baugruppen auf, wobei jede aktive Baugruppe eine elektrisch leitende Trägerplatte aufweist, und die Trägerplatten der aktiven Baugruppen zusammen die erste Hauptelektrode bilden. Weiter ist jede Ringanordnung durch die aktiven Baugruppen in Ringsegmente aufgeteilt, wobei die aktiven Leistungshalbleiterbauelemente des Ringsegmentes auf der Trägerplatte angeordnet sind, und die Kontrolleiterbahn der jeweiligen Ringanordnung in Kontrolleiterbahnsegmente der Ringanordnung unterteilt ist, wobei die Kontrollelektrode jedes Leistungshalbleiterbauelementes des jeweiligen Ringsegments mit dem Kontrolleiterbahnsegment des jeweiligen Ringsegments verbunden ist.

Durch diese Ausführungsform des Leistungshalbleitermoduls ist eine wirtschaftliche Produktion möglich, da Baugruppen produziert und getestet werden können. Funktionstüchtige Baugruppen können zu einem Leistungshalbleitermodul kombiniert werden.

Gemäss einer bevorzugten Ausführungsform des Leistungshalbleitermoduls überlappen sich die Ringanordnungen nicht. Mit anderen Worten, die Ringanordnungen sind überlappungsfrei.

Durch diese Ausführungsform ist eine kostengünstige Produktion möglich.

Gemäss einer bevorzugten Ausführungsform des Leistungshalbleitermoduls sind alle aktiven Leistungshalbleiterbauelemente in der Ringanordnung beziehungsweise den Ringanordnungen angeordnet.

Durch diese Ausführungsform des Leistungshalbleitermoduls kann das Schaltverhalten aller Leistungshalbleiterbauelemente optimiert werden.

Gemäss einer bevorzugten Ausführungsform des Leistungshalbleitermoduls sind die aktiven Baugruppen des Leistungshalbleitermoduls alle gleich ausgebildet.

Durch diese Ausführungsform ist eine wirtschaftliche Produktion möglich.

Gemäss einer bevorzugten Ausführungsform des Leistungshalbleitermoduls ist zwischen der zweiten Hauptelektrode des Leistungshalbleitermoduls und jedem steuerbaren Leistungshalbleiterbauelement ein elektrisch leitendes Kontaktelement angeordnet, welches die zweite Hauptelektrode mit der zweiten Elektrode des Leistungshalbleiterbauelements verbindet, wobei durch das Kontaktelement und das Leistungshalbleierbauelement eine Stromführungsrichtung definiert wird, welche zumindest annähern rechtwinklig zur ersten Hauptelektrode ist.

Durch diese Ausführungsform des Leistungshalbleitermoduls lässt sich ein stapelbares Modul mit einem verhältnismässig einfachen Aufbau realisieren.

Gemäss einer weiteren Ausführungsform des Leistungshalbleitermoduls, welche sich mit sämtlichen andere Ausführungsformen kombinierbar ist, ist die erste Hauptelektrode parallel zur zweiten Hauptelektrode.

Gemäss einer bevorzugen Ausführungsform des Leistungshalbleitermoduls ist jedes Kontaktelement als Presskontakt ausgebildet.

Diese Ausführungsform ermöglicht auf einfachste Weise eine Realisierung eines elektrischen Kontaktes mittels Druck, wobei zum Herstellen des elektrischen Kontaktes auf ein Lot oder andere elektrische Verbindungsschicht verzichtet werden kann. Weiter ermöglicht diese Ausführungsform eine Kompensation der unterschiedlichen Bauhöhen der Leistungshalbleiterbauelemente wie auch der Kontaktelemente. Die unterschiedlichen Bauhöhen sind produktionsbeding. Weiter ermöglicht diese Ausführungsform dank dem Federweg des Presskonaktes ein adaptives Ausrichten der ersten Hauptelektrode gegenüber der zweiten Hauptelektrode..

Gemäss einer bevorzugten Ausführungsform des Leistungshalbleitermoduls verläuft die weitere elektrische Verbindung zumindest im Wesentlichen parallel zur Stromführungsrichtung.

Gemäss einer bevorzugten Ausführungsform des Leistungshalbleitermoduls weist das Leistungshalbleitermodul einen Rahmen aus Isoliermaterial auf, in welchen die aktiven Baugruppen eingesetzt sind.

Dank dieser Ausführungsform kann das Leistungshalbleitermodul wirtschaftlich aus aktiven Baugruppen aufgebaut werden.

Gemäss einer bevorzugen Ausführungsform des Leistungshalbleitermoduls weist das Leistungshalbleitermodul ein zentrales Durchgangsloch aufweist.

Dank dieser Ausführungsform können Leistungshalbleitermodule, welche gestapelt sind, mittels eines Stabes, welcher durch die Durchgangslöcher geführt wird, gegeneinander verspannt werden, wodurch zwischen anliegenden ersten Hauptelektroden und zweiten Hauptelektroden ein optimaler Kontaktdruck hergestellt ist. Optional können zwischen benachbarter erster Hauptelektrode und zweiter Hauptelektrode zweier Leistungshalbleitermodule ein Kühlkörper angeordnet sein.

Gemäss einer weiteren bevorzugten Ausführungsform des Leistungshalbleitermoduls sind die schaltbaren Leistungshalbleiterbauelemente als rückwärtsleitende IGBTs ausgebildet, welche auch als RC-IGBTs bezeichnet werden. Alternativ können auch herkömmliche IGBTs verwendet werden, wobei in diesem Fall zusätzlich antiparallele Leistungshalbleiterdioden zu den IGBTs anzuordnen sind. Die Dioden können beispielsweise anstelle eines schaltbaren Leistungshalbleiterbauelementes angeordnet sein. In den Ausführungsformen mit aktiven Baugruppen, können die schaltbaren Leistungshalbleiterbauelemente einer der Baugruppen durch Leistungshalbeiterdioden ausgebildet sein, wobei in diesem Fall der Aufbau der Baugruppe vereinfacht werden kann, da die Leistungshalbleiterdioden keine Kontrollelektroden aufweisen. Beispielsweise könnten im Rahmen zwei aktive Baugruppen mit Leistungshalbleiterdioden und vier aktive Baugruppen mit IGBTs bestückt sein. Andere Anordnungen sind auch denkbar und für den Fachmann offensichtlich.

Die vorstehend aufgeführten und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

### Kurze Beschreibung der Zeichnungsfiguren

Es zeigen rein schematisch:
Fig. 1 in Draufsicht ein geöffnetes Leistungshalbleitermodul gemäss einer ersten Ausführungsform, wobei eine zweite Hauptelektrode sowie ein Kontrollanschluss entfernt sind;
Fig. 2 in Schnittdarstellung entlang der in Fig. 1 eingezeichneten Schnittlinie A-B; wobei die zweite Hauptelektrode und der Kontrollanschluss gezeigt sind;
Fig. 3 in Draufsicht ein geöffnetes Leistungshalbleitermodul gemäss einer zweiten Ausführungsform, wobei die zweite Hauptelektrode sowie der Kontrollanschluss entfernt sind;
Fig. 4 in perspektivischer Darstellung ein geöffnetes Leistungshalbleitermodul gemäss einer weiteren Ausführungsform, wobei die zweite Hauptelektrode entfernt ist;
Fig. 5 in perspektivischer Darstellung das Leistungshalbleitermodul gemäss Fig. 4, wobei die zweite Hauptelektrode ebenfalls gezeigt ist;
Fig. 6 in Draufsicht eine aktive Baugruppe, welche in dem in Fig. 4 und 5 gezeigten Leistungshalbleitermodul verwendet wird; und
Fig. 7 die in Fig. 6 gezeigte aktive Baugruppe in perspektivischer Darstellung, wobei ein Baugruppenrahmen zwecks besserer Sichtbarkeit der einzelnen Elemente der aktiven Baugruppe nicht gezeigt ist.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen und werden daher nur einmal beschrieben.

### Beschreibung der Ausführungsarten

Die nachfolgend beschriebenen Ausführungsformen stehen beispielhaft für den Erfindungsgegenstand und haben keine beschränkende Wirkung.

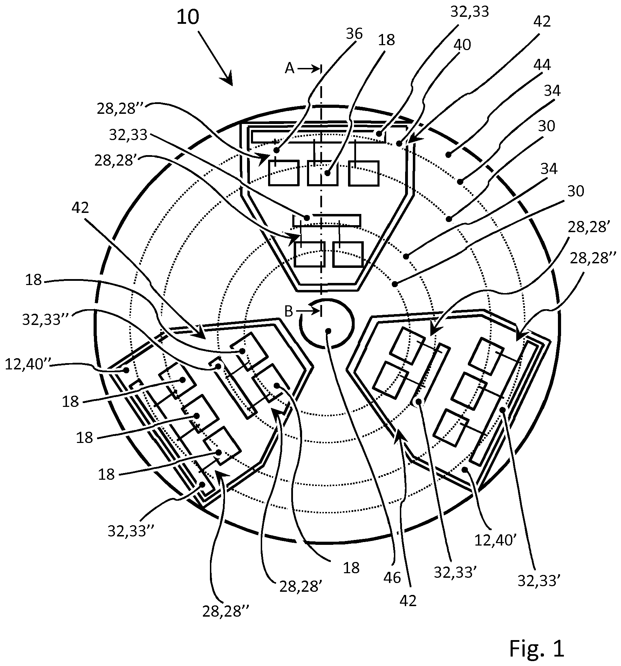

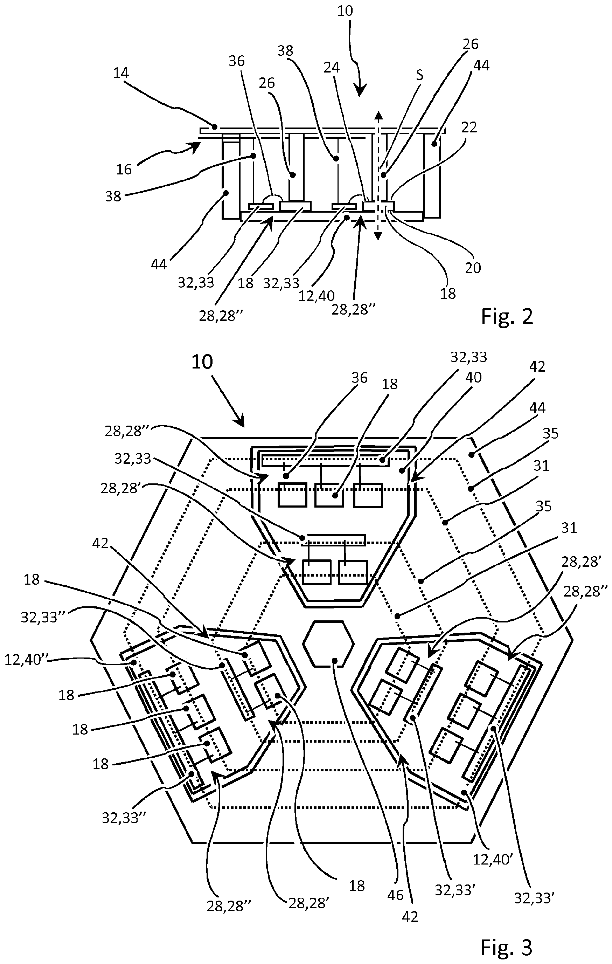

Fig. 1 und Fig. 2 zeigen eine erste Ausführungsform eines Leistungshalbleitermodul 10 mit einer ersten Hauptelektrode 12 und einer zweiten Hauptelektrode 14, welche nur in Fig. 2 gezeigt ist. Das Leistungshalbleitermodul 10 weist weiter einen, in Fig. 2 gezeigten Kontrollanschluss 16 auf, welcher gegenüber der zweiten Hauptelektrode 14 in bekannter Art und Weise isoliert an der zweiten Hauptelektrode 14 angeordnet ist. Wie insbesondere Fig. 2 zeigt, sind zwischen der ersten Hauptelektrode 12 und der zweiten Hauptelektrode 14 steuerbare Leistungshalbleiterbauelemente 18 angeordnet. Jedes steuerbare Leistungshalbleiterbauelement 18 weist eine erste Elektrode 20, eine zweite Elektrode 22 und eine Kontrollelektrode 24 auf. Die erste Elektrode 20 jedes steuerbaren Leistungshalbleiterbauelements 18 ist mittels einer Verbindungsschicht elektrisch mit der ersten Hauptelektrode 12 verbunden. Die Verbindungsschicht kann beispielsweise durch eine Lotschicht oder durch eine durch ein Sinterverfahren hergestellte Verbindungsschicht ausgebildet sein. Die zweite Elektrode 22 ist über ein Kontaktelement 26 mit der zweiten Hauptelektrode 14 elektrisch verbunden.

Wie insbesondere Fig. 1 zeigt, sind die steuerbaren Leistungshalbleiterbauelemente 18 in einer inneren Ringanordnung 28' und einer äusseren Ringanordnung 28" angeordnet, welche konzentrisch zueinander sind. Anstelle dieser zwei Ringanordnungen 28', 28" können die Leistungshalbleiterbauelemente 18 auch in mehreren, zueinander konzentrischen Ringanordnungen angeordnet sein. Ringanordnungen werden allgemein durch das Bezugszeichen 28 bezeichnet. Weiter überlappen sich die einzelnen, konzentrisch zueinander angeordneten Ringanordnungen nicht. Sie sind folglich überlappungsfrei.

In jeder Ringanordnung 28, insbesondere in der in Fig. 1 gezeigten inneren und äusseren Ringanordnung 28', 28" sind die steuerbaren Leistungshalbeiterbauelemente 18 entlang einer ersten Kreislinie 30 der jeweiligen Ringanordnung 28 angeordnet. Weiter weist jede Ringanordnung 28 eine Kontrollleiterbahn 32 auf, welche isoliert von der ersten Hauptelektrode 12 auf dieser angeordnet ist. Die Kontrolleiterbahn 32 der jeweiligen Ringanordnung 28 verläuft entlang einer zweiten Kreislinie 34, wobei die zweite Kreislinie 34 konzentrisch zur ersten Kreislinie 30 liegt. Wie in Fig. 1 gezeigt, ist die Kontrollleiterbahn 32 der jeweiligen Ringanordnung 28 durch mehrere Kontrollleiterbahnsegmente 33, 33', 33" ausgebildet. Jede Kontrollelektrode 24 der steuerbaren Leistungshalbleiterbauelemente 18 der Ringanordnung 28 ist über eine elektrische Verbindung 36, beispielsweise über einen Draht, mit der Kontrollleiterbahn 32 verbunden, wobei die Verbindung 36 bevorzugt im Wesentlichen in radialer Richtung bezüglich der erste Kreislinie 30 beziehungsweise der zweiten Kreislinie 34 verläuft.

Wie Fig. 2 zeigen, ist die Kontrollleiterbahn 32 bzw. jedes Kontrollleiterbahnsegment 33, 33', 33" über eine weitere elektrische Verbindung 38 mit dem Kontrollanschluss 16 verbunden. Alternative ist es auch möglich, die einzelnen Kontrollleiterbahnsegmente 33, 33', 33" entlang der zweiten Kreislinie 34 untereinander zu verbinden und zumindest eines der Kontrolleiterbahnsegmente 33, 33', 33" über die weitere elektrische Verbindung 38 mit dem Kontrollanschluss 16 zu verbinden.

Weiter ist es bevorzugt, dass die weitere elektrische Verbindung 38 parallel zu einer weiter unten definierten Stromführungsrichtung S verläuft. Alternativ, kann die weitere elektrische Verbindung 38 im Wesentlichen auch auf einer konzentrisch zur ersten Kreislinie 30 oder zweiten Kreislinie 34 liegenden Kreiszylindermantelfläche verlaufen. Als weitere Alternative ist auch denkbar, dass die weitere elektrische Verbindung gegenüber der aktiven Baugruppe 42 jeweils gleich ausgerichtet ist.

Wie Fig. 1 zeigt, liegt die zweite Kreislinie 34 der jeweiligen Ringanordnung 28 ausserhalb der ersten Kreislinie 30 derselben Ringanordnung 28. Anders ausgedrückt, ist der Radius der zweiten Kreislinie 34 grösser als der Radius der ersten Kreislinie 30.

Wie Fig. 1 weiter zeigt, ist die erste Hauptelektrode 12 dreiteilig ausgebildet. Im Allgemeinen kann die erste Hauptelektrode 12 durch eine beliebige Anzahl von Trägerplatten ausgebildet sein, welche zusammen die erste Hauptelektrode 12 bilden. Im vorliegenden Ausführungsbeispiel ist die erste Hauptelektrode 12 durch die drei Trägerplatten 40, 40', 40" ausgebildet. Durch die Trägerplatten 40, 40', 40" werden im Leistungshalbleitermodul 10 aktive Baugruppen 42 ausgebildet. Weiter wird durch die aktiven Baugruppen 42 jede Ringanordnung 28, 28', 28" in Ringsegmente unterteilt. Wie Fig. 1 zeigt, werden durch die aktiven Baugruppen die innere Ringanordnung 28' wie auch die äussere Ringanordnung 28" in je drei Ringsegmente aufgeteilt.

Auf einer ersten Seite jeder Trägerplatte 40, 40', 40" sind folglich die aktiven Leistungshalbleiterblauelemente 18 angeordnet und elektrisch leitend mit dieser verbunden. Die Hauptelektrode 12 wird insbesondere durch jene Seite der Trägerplatte ausgebildet, welche den ersten Seite gegenüberliegend ist.

Wie Fig. 1 wie auch Fig. 2 weiter zeigt, sind die aktiven Baugruppen 42 durch einen Rahmen 44 gehalten beziehungsweise in einen Rahmen 44 eingesetzt. Der Rahmen 44 ist aus einem Isolierstoff gefertigt. Fig. 1 zeigt weiter, dass das Leistungshalbleitermodul 10 mittig ein optionales Durchgangsloch 46 aufweist. Durch dieses kann ein Stab geführt werden, mittels welchem mehrere, aufeinander gestapelte Leistungshalbleitermodule 10 gegeneinander verspannt werden können.

Wie Fig. 1 weiter zeigt, sind alle steuerbaren Leistungshalbleiterbauelemente 18 in den Ringanordnungen 28, 28', 28" angeordnet. Steuerbare Leistungshalbleiterbauelemente 18 können aber auch ausserhalb von Ringanordnungen angeordnet sein. Um die Leistungsfähigkeit des Leistungshalbleitermoduls zu erhöhen könnte in der Mitte des Leistungshalbleitermoduls anstelle des Durchgangslochs ein einziges Leistungshalbleiterbauelement angeordnet sein.

Wie insbesondere Fig. 2 zeigt, ist die zweite Elektrode 22 jedes Leistungshalbleiterbauelement 18 durch das Kontaktelement 26 kontaktiert. Das Kontaktelement 26 stellt die elektrische Verbindung zwischen der zweiten Elektrode 22 des Leistungshalbleiterbauelements 18 und der zweiten Hauptelektrode 14 des Leistungshalbleitermodul 10 her. Weiter ist das Kontaktelement 26 ein wichtiges Element, damit das Leistungshalbleitermodul 10 im Fehlerfall in einen leitenden Zustand übergeht, welcher im Englischen als short circuit failure mode (SCFM) bekannt ist. Dies ist aus dem Stand der Technik bekannt und ist beispielsweise in, EP 0 989 611 A2, US 6426561, EP 1 403 923 A1 oder WO 2012/107482 A2 beschrieben.

Durch das Kontaktelement 26 und durch das vom jeweiligen Kontaktelement 26 kontaktierte Leistungshalbleiterbauelement 18 wird eine Stromführungsrichtung S definiert. Diese ist zumindest annähernd rechtwinklig zur ersten Hauptelektrode 12.

Das Kontaktelement 26 kann, wie beispielsweise in EP 0 989 611 A2, US 6426561 oder EP 1 403 923 A1 beschrieben einen Presskontakt aufweisen. Dieser kann wie aus dem Stand der Technik bekannt durch eine Feder realisiert werden. Weiter kann das Kontaktelement 26 Aluminium, Silber, Gold, Kupfer oder Magnesium aber auch eine Metallschicht aus einem anderen geeigneten Material aufweisen, die im Fehlerfall eine Ausbildung einer elektrisch leitenden Verbindung zwischen der ersten Hauptelektrode 12 und der zweiten Hauptelektrode 14 ermöglichen bzw. unterstützen. Das Metall der Metallschicht soll mit dem Material des Leistungshalbleiterbauelements 18 ein Eutektikum bilden können. Weiter muss die Dicke der Metallschicht derart bemessen sein, dass im Fehlerfall das Material der Metallschicht mit dem Material des Leistungshalbleiterbauelements einen elektrisch leitenden Kanal bilden kann wie dies im genannten Stand der Technik beschrieben ist. Weiter kann im Kontaktelement 26 eine Schicht vorgesehen sein, die thermische Spannungen aufgrund von Temperaturschwankungen kompensiert, sodass das Halbleiterbauelement 18 mechanisch, aufgrund thermischer Schwankungen, möglichst unbelastet ist. Dies kann durch eine Schicht erzielt werden, welche einen ähnlichen thermischen Ausdehnungskoeffizient aufweist, wie das Leistungshalbleiterbauelement 18 selbst.

Alternativ kann das Kontaktelement 26 auch ohne Presskontakt beziehungsweise ohne eine Feder ausgebildet sein. Ein derartiges Kontaktelement ist aus WO 2012/107482 A2 bekannt.

Um das Leistungshalbleiterbauelement 18 weiter gegen mechanische Belastungen aufgrund von thermischen Schwankungen zu schützen, kann beispielsweise zwischen dem Leistungshalbleiterbauelement 18 und der ersten Hauptelektrode 12 eine weitere Schicht aus einem Material mit einem ähnlichen thermischen Ausdehnungskoeffizient wie die des Leitungshalbleiterbauelement 18 vorgesehen sein. Alternativ kann auch die erste Hauptelektrode 12 selbst aus einem derartigen Material gefertigt sein bzw. eine Schicht aus einem derartigen Material aufweisen.

Fig. 3 zeigt eine weitere Ausführungsform der Erfindung. Diese Ausführungsform ist weitgehend gleich zu der vorstehend beschriebenen Ausführungsform ausgebildet. Im weiteren wird nur auf die Unterschiede eingegangen. Die in Fig. 3 gezeigte Ausführungsform unterscheidet sich von der ersten, in Fig. 1 und 2 gezeigten Ausführungsform dadurch, dass die ersten Kreislinie 30 jeder Ringanordnung 28 durch ein erstes Sechseck 31 und die dazugehörige zweite Kreislinie 34 durch ein zweites Sechseck 35 angenähert ist, wobei die Ecken des ersten Sechseck auf die Ecken des zweiten Sechsecks ausgerichtet sind. Weiter zeigt diese Ausführungsform auch, dass der Rahmen 44 beziehungsweise das Gehäuse des Leistungshalbleitermoduls 10 eine sechseckige Form haben kann. Ebenso kann das Durchgangsloch 46 eine sechseckige Form haben.

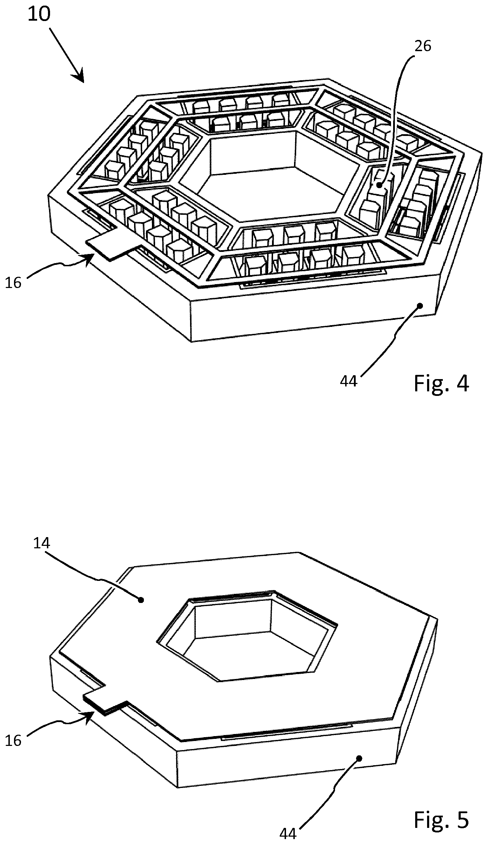

In der in Fig. 3 gezeigten Ausführungsform sind in das sechseckige Leistungshalbleitermodul 10 drei aktive Baugruppen 42 eingesetzt. Anstelle von drei aktiven Baugruppen 42 können auch sechs aktive Baugruppen in den Rahmen 44 eingesetzt werden, wie dies in Fig. 4 gezeigt ist.

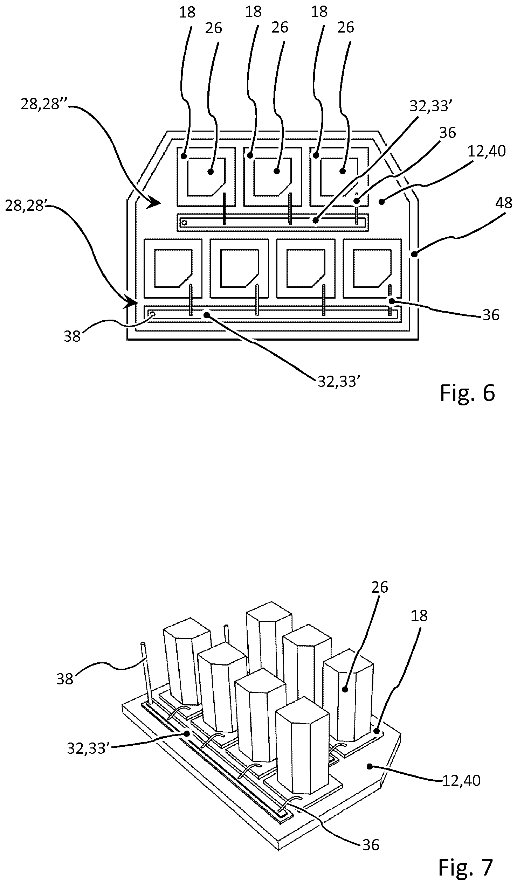

Fig. 4 zeigt eine weitere Ausführungsform des erfindungsgemässen Leistungshalbleitermoduls 10, dessen aktive Baugruppen 42 in Fig. 6 und 7 gezeigt sind. Diese Ausführungsform ist wiederum weitgehend gleich zu den vorstehend beschriebenen Ausführungsformen ausgebildet und es wird im Folgenden nur auf die Unterschiede eingegangen. Diese Ausführungsform unterscheidet sich von den anderen, bereits diskutierten Ausführungsformen durch die Anzahl der elektrisch parallel zueinander angeordneten Leistungshalbleiterbauelemente 18. Weiter zeigt diese Ausführungsform einen Baugruppenrahmen 48, durch welchen zusammen mit der Trägerplatte 40 eine Art Wanne gebildet wird. Diese Wanne ist bevorzugt mit einem Isoliergel, wie beispielsweise Silikongel, oder einem anderen Isolierstoff ausgefüllt.

Weiter zeigt Fig. 4 eine Ausführungsform des Kontaktanschlusses 16.

In Fig. 5 ist das in Fig. 4 gezeigte Leistungshalbleitermodul 10 gezeigt, wobei die zweite Hauptelektrode auf den Rahmen 44 wie auch auf den Kontaktanschluss 16 aufgelegt ist. Durch das Auflegen treten die Kontaktelemente 26 in elektrischen Kontakt mit der zweiten Hauptelektrode 14.

In den vorstehenden Ausführungsformen wurden sechseckige Leistungshalbleitermodule beschrieben. Selbstverständlich kann das Leistungshalbleitermodul eine beliebige Anzahl von Ecken aufweisen, wobei die Anzahl der Ecken typischerweise gleich oder grösser als 3 und kleiner 10 ist, jedoch auch grösser sein könnte. Je grösser die Anzahl der Ecken ist, desto mehr nähert sich die n-eckige Ausführungsform der ersten Ausführungsform an.

Auch bei einer n-eckigen Ausführungsform liegen die Leistungshalbleiterbauelemente der entsprechenden Ringanordnung zumindest annähernd entlang einer ersten Kreislinie. Die erste Kreislinie 30 lässt sich jedoch auch durch ein erstes Vieleck 31 mit derselben Anzahl von Ecken annähern. Ebenso kann die zweite Kreislinie 34 der Ringanordnung durch ein zweites Vieleck 35 mit derselben Anzahl von Ecken angenähert werden.

In einer weiteren, in den Figuren nicht gezeigten Ausführungsform weist die elektrische Verbindung zwischen dem Kontrollanschluss 16 und jeder Kontrollelektrode 24 einen Widerstand auf.

In den bisherig beschriebenen und in den Figuren gezeigten Ausführungsformen sind die aktiven Baugruppen 42 des Leistungshalbleitermoduls 10 jeweils gleich ausgebildet. Um die beschriebene Ringstruktur möglichst einem Kreisring anzunähern kann es auch sinnvoll sein zwei oder mehr Typen von Baugruppen 42 zu verwenden, die geometrisch unterschiedlich aufgebaut sind. Beispielsweise kann die Form der Trägerplatte variiert und die Anzahl der darauf angeordneten Leistungshalbleiterbauelemente daran angepasst werden.

### Bezugszeichenliste

- 10: Leistungshalbleitermodul
- 12: erste Hauptelektrode
- 14: zweite Hauptelektrode
- 16: Kontrollanschluss
- 18: Leistungshalbleiterbauelement
- 20: erste Elektrode
- 22: zweite Elektrode
- 24: Kontrollelektrode
- 26: Kontaktelement
- 28: Ringanordnung
- 28': innere Ringanordnung
- 28": äussere Ringanordnung
- 30: erste Kreislinie
- 31: erstes Sechseck, erstes Vieleck
- 32: Kontrollleiterbahn
- 33, 33', 33": Kontrollleiterbahnsegment
- 34: zweite Kreislinie
- 35: zweites Sechseck, zweites Vieleck
- 36: elektrische Verbindung
- 38: weitere elektrische Verbindung
- 40, 40', 40": Trägerplatte
- 42: aktive Baugruppen
- 44: Rahmen
- 46: Durchgangsloch
- 48: Baugruppenrahmen
- S: Stromführungsrichtung

## Patentansprüche

1. Leistungshalbleitermodul (10) mit einer ersten Hauptelektrode (12), einer zweiten Hauptelektrode (14), und einem Kontrollanschluss (16) und mit steuerbaren Leistungshalbleiterbauelementen (18), welche zwischen der ersten Hauptelektrode (12) und der zweiten Hauptelektrode (14) angeordnet sind, wobei jedes steuerbare Leistungshalbleiterbauelement (18) eine erste Elektrode (20), eine zweite Elektrode (22) und eine Kontrollelektrode (24) aufweist und die erste Elektrode (20) jedes steuerbaren Leistungshalbleiterbauelementes (18) mit der ersten Hauptelektrode (12), die zweite Elektrode (22) jedes steuerbaren Leistungshalbleiterbauelementes (18) mit der zweiten Hauptelektrode (14) und die Kontrollelektrode (24) jedes steuerbaren Leistungshalbleiterbauelementes (18) mit dem Kontrollanschluss (16)-elektrisch verbunden ist, wobei zumindest ein Teil der steuerbaren Leistungshalbleiterbauelemente (18) in mehreren Ringanordnungen (28, 28', 28") angeordnet sind,
wobei die steuerbaren Leistungshalbleiterbauelemente (18) jeder Ringanordnung (28, 28', 28") der mehreren Ringanordnungen (28, 28', 28") zumindest annähernd entlang einer ersten Kreislinie (30) der jeweiligen Ringanordnung (28, 28', 28") angeordnet sind und eine Kontrollleiterbahn (32) der jeweiligen Ringanordnung (28, 28', 28") auf der ersten Hauptelektrode (12) angeordnet ist, wobei die Kontrolleiterbahn (32) der jeweiligen Ringanordnung (28, 28', 28") zumindest annähernd entlang einer zweiten Kreislinie (34) der jeweiligen Ringanordnung (28, 28', 28") verläuft, und die zweite Kreislinie (34) der jeweiligen Ringanordnung (28, 28', 28") konzentrisch und ausserhalb zur ersten Kreislinie (30) der jeweiligen Ringanordnung (28, 28', 28") verläuft, wobei die Kontrollelektrode (24) jedes steuerbaren Leistungshalbleiterbauelementes (18) der jeweiligen Ringanordnung (28, 28', 28") über eine elektrische Verbindung (36) mit der Kontrollleiterbahn (32) der jeweiligen Ringanordnung (28, 28', 28") verbunden ist und die Kontrolleiterbahn (32) der jeweiligen Ringanordnung (28, 28', 28") über eine weitere elektrische Verbindung (38) mit dem Kontrollanschluss (16) verbunden ist;
wobei zwischen der zweiten Hauptelektrode (14) des Leistungshalbleitermoduls (10) und jedem steuerbaren Leistungshalbleiterbauelement (18) ein elektrisch leitendes Kontaktelement (26) angeordnet ist, welches die zweite Hauptelektrode (14) mit der zweiten Elektrode des Leistungshalbleiterbauelements (18) verbindet,
**dadurch gekennzeichnet, dass** durch das Kontaktelement (26) und das Leistungshalbleiterbauelement (18) eine Stromführungsrichtung (S) definiert wird, welche rechtwinklig zur ersten Hauptelektrode (12) ist; und die weitere elektrische Verbindung (38) parallel zur Stromführungsrichtung (S) verläuft.

2. Leistungshalbleitermodul nach Anspruch 1, **dadurch gekennzeichnet, dass** die erste Kreislinie (30) jeder Ringanordnung (28, 28', 28") durch ein erstes Vieleck (31) und die dazugehörige zweite Kreislinie (34) jeder Ringanordnung (28, 28', 28") durch ein zweites Vieleck (35) mit derselben Anzahl Ecken wie das erste Vieleck (31) angenähert ist, wobei die Ecken des ersten Vieleckes (31) auf die Ecken des zweiten Vieleckes (35) ausgerichtet sind.

3. Leistungshalbleitermodul nach einem der Ansprüche 1 bis 2, **dadurch gekennzeichnet, dass** das Leistungshalbleitermodul (10) aktive Baugruppen (42) aufweist, wobei jede aktive Baugruppe (42) eine Trägerplatte (40, 40', 40") aufweist, und die Trägerplatten (40, 40', 40") der aktiven Baugruppen (42, 42', 42") zusammen die erste Hauptelektrode (12) bilden,
jede Ringanordnung (28, 28', 28") durch die aktiven Baugruppen (42) in Ringsegmente aufgeteilt ist, wobei die aktiven Leistungshalbleiterbauelemente (18) des Ringsegmentes auf der Trägerplatte (40) angeordnet sind, und die Kontrolleiterbahn (32) der jeweiligen Ringanordnung (28, 28', 28") in Kontrolleiterbahnsegmente (33,33',33") der Ringanordnung (28, 28', 28") unterteilt ist, wobei die Kontrollelektrode (24) jedes Leistungshalbleiterbauelementes (18) des jeweiligen Ringsegments mit dem Kontrolleiterbahnsegment (33, 33', 33') des jeweiligen Ringsegments verbunden ist.

4. Leistungshalbleitermodul nach Anspruch 3, **dadurch gekennzeichnet, dass** die aktiven Baugruppen (42) des Leistungshalbleitermoduls (10) alle gleich ausgebildet sind.

5. Leistungshalbleitermodul nach Anspruch 3 oder 4, **dadurch gekennzeichnet, dass** das Leistungshalbleitermodul (1) einen Rahmen (40) aus Isoliermaterial aufweist, in welchen die aktiven Baugruppen (30) eingesetzt sind.

6. Leistungshalbleitermodul nach einem der Ansprüche 1 bis 5, **dadurch gekennzeichnet, dass** sich die Ringanordnungen nicht überlappen beziehungsweise überlappungsfrei sind.

7. Leistungshalbleitermodul nach einem der Ansprüche 1 bis 6, **dadurch gekennzeichnet, dass** alle aktiven Leistungshalbleiterbauelemente (18) in den Ringanordnungen (28, 28', 28") angeordnet sind.

8. Leistungshalbleitermodul nach Anspruch 7, **dadurch gekennzeichnet, dass** jedes Kontaktelement (26) als Presskontakt ausgebildet ist.

9. Leistungshalbleitermodul nach einem der Ansprüche 1 bis 8, **dadurch gekennzeichnet, dass** das Leistungshalbleitermodul ein zentrales Durchgangsloch aufweist.

## Claims

1. Power semiconductor module (10) comprising a first main electrode (12), a second main electrode (14), and a control terminal (16), and comprising controllable power semiconductor components (18) arranged between the first main electrode (12) and the second main electrode (14), wherein each controllable power semiconductor component (18) has a first electrode (20), a second electrode (22) and a control electrode (24), and the first electrode (20) of each controllable power semiconductor component (18) is electrically connected to the first main electrode (12), the second electrode (22) of each controllable power semiconductor component (18) is electrically connected to the second main electrode (14), and the control electrode (24) of each controllable power semiconductor component (18) is electrically connected to the control terminal (16), wherein at least one portion of the controllable power semiconductor components (18) are arranged in a plurality of ring arrangements (28, 28', 28"),
wherein the controllable power semiconductor components (18) of each ring arrangement (28, 28', 28") of the plurality of ring arrangements (28, 28', 28") are arranged at least approximately along a first circular line (30) of the respective ring arrangement (28, 28', 28"), and a control conductor track (32) of the respective ring arrangement (28, 28', 28") is arranged on the first main electrode (12), wherein the control conductor track (32) of the respective ring arrangement (28, 28', 28") runs at least approximately along a second circular line (34) of the respective ring arrangement (28, 28', 28"), and the second circular line (34) of the respective ring arrangement (28, 28', 28") runs concentrically and outside with respect to the first circular line (30) of the respective ring arrangement (28, 28', 28"), wherein the control electrode (24) of each controllable power semiconductor component (18) of the respective ring arrangement (28, 28', 28") is connected via an electrical connection (36) to the control conductor track (32) of the respective ring arrangement (28, 28', 28"), and the control conductor track (32) of the respective ring arrangement (28, 28', 28") is connected via a further electrical connection (38) to the control terminal (16);
wherein an electrically conductive contact element (26) is arranged between the second main electrode (14) of the power semiconductor module (10) and each controllable power semiconductor component (18), said contact element connecting the second main electrode (14) to the second electrode of the power semiconductor component (18), **characterized in that** the contact element (26) and the power semiconductor component (18) define a current-carrying direction (S) that is at right angles to the first main electrode (12);
and the further electrical connection (38) runs parallel to the current-carrying direction (S).

2. Power semiconductor module according to Claim 1, **characterized in that** the first circular line (30) of each ring arrangement (28, 28', 28") is approximated by a first polygon (31), and the associated second circular line (34) of each ring arrangement (28, 28', 28") is approximated by a second polygon (35) having the same number of vertices as the first polygon (31), wherein the vertices of the first polygon (31) are aligned with the vertices of the second polygon (35).

3. Power semiconductor module according to either of Claims 1 and 2, **characterized in that** the power semiconductor module (10) comprises active assemblies (42), wherein each active assembly (42) has a carrier plate (40, 40', 40"), and the carrier plates (40, 40', 40") of the active assemblies (42, 42', 42") together form the first main electrode (12),
each ring arrangement (28, 28', 28") is divided into ring segments by the active assemblies (42), wherein the active power semiconductor components (18) of the ring segment are arranged on the carrier plate (40), and the control conductor track (32) of the respective ring arrangement (28, 28', 28") is subdivided into control conductor track segments (33, 33', 33") of the ring arrangement (28, 28', 28"), wherein the control electrode (24) of each power semiconductor component (18) of the respective ring arrangement is connected to the control conductor track segment (33, 33', 33") of the respective ring arrangement.

4. Power semiconductor module according to Claim 3, **characterized in that** the active assemblies (42) of the power semiconductor module (10) are all embodied identically.

5. Power semiconductor module according to Claim 3 or 4, **characterized in that** the power semiconductor module (1) has a frame (40) composed of insulating material, the active assemblies (30) being inserted into said frame.

6. Power semiconductor module according to any of Claims 1 to 5, **characterized in that** the ring arrangements do not overlap, or are free of overlap.

7. Power semiconductor module according to any of Claims 1 to 6, **characterized in that** all the active power semiconductor components (18) are arranged in the ring arrangements (28, 28', 28").

8. Power semiconductor module according to Claim 7, **characterized in that** each contact element (26) is embodied as a press contact.

9. Power semiconductor module according to any of Claims 1 to 8, **characterized in that** the power semiconductor module has a central through hole.

## Revendications

1. Module de semi-conducteurs de puissance (10) comportant une première électrode principale (12), une deuxième électrode principale (14) et une borne de commande (16), et comportant des composants semi-conducteurs de puissance (18) commandables disposés entre la première électrode principale (12) et la deuxième électrode principale (14), dans lequel chaque composant semi-conducteur de puissance (18) commandable comporte une première électrode (20), une deuxième électrode (22) et une électrode de commande (24) et la première électrode (20) de chaque composant semi-conducteur de puissance (18) commandable est électriquement reliée à la première électrode principale (12), la deuxième électrode (22) de chaque composant semi-conducteur de puissance (18) commandable est électriquement reliée à la deuxième électrode principale (14), et l'électrode de commande (24) de chaque composant semi-conducteur de puissance commandable (18) est électriquement reliée à la borne de commande (16), dans lequel une partie au moins des composants semi-conducteurs de puissance (18) commandables sont disposés selon plusieurs agencements en cercle (28, 28', 28"),
dans lequel les composants semi-conducteurs de puissance (18) commandables de chaque agencement en cercle (28, 28', 28") des multiples agencements en cercle (28, 28', 28") sont disposés au moins approximativement le long d'une première circonférence (30) de l'agencement en cercle (28, 28', 28") respectif et une piste conductrice de commande (32) de l'agencement en cercle (28, 28', 28") respectif est disposée sur la première électrode principale (12), dans lequel la piste conductrice de commande (32) de l'agencement en cercle (28, 28', 28") respectif s'étend au moins approximativement le long d'une deuxième circonférence (34) de l'agencement en cercle (28, 28', 28") respectif, et la deuxième circonférence (34) de l'agencement en cercle (28, 28', 28") respectif s'étend concentriquement et en dehors de la première circonférence (30) de l'agencement en cercle (28, 28', 28") respectif, dans lequel l'électrode de commande (24) de chaque composant semi-conducteur de puissance (18) commandable de l'agencement en cercle (28, 28', 28") respectif est reliée à la piste conductrice de commande (32) de l'agencement en cercle (28, 28', 28") respectif par une liaison électrique (36) et la piste conductrice de commande (32) de l'agencement en cercle (28, 28', 28") respectif est reliée à la borne de commande (16) par une autre liaison électrique (38) ;
dans lequel un élément de contact (26) électriquement conducteur est disposé entre la deuxième électrode principale (14) du module de semi-conducteurs de puissance (10) et chaque composant semi-conducteur de puissance (18) commandable, lequel élément de contact relie la deuxième électrode principale (14) à la deuxième électrode du composant semi-conducteur de puissance (18), **caractérisé en ce qu'**une direction de conduction de courant (S), qui est perpendiculaire à la première électrode principale (12), est définie par l'élément de contact (26) et le dispositif de semi-conducteurs de puissance (18) ;
et l'autre liaison électrique (38) est parallèle à la direction de conduction de courant (S).

2. Module de semi-conducteurs de puissance selon la revendication 1, **caractérisé en ce que** la première circonférence (30) de chaque agencement en cercle (28, 28', 28") est approchée par un premier polygone (31) et la deuxième circonférence (34) associée de chaque agencement en cercle (28, 28', 28") est approchée par un deuxième polygone (35) ayant le même nombre d'angles que le premier polygone (31), dans lequel les angles du premier polygone (31) sont alignés sur les angles du deuxième polygone (35).

3. Module de semi-conducteurs de puissance selon l'une des revendications 1 à 2, **caractérisé en ce que** le module de semi-conducteurs de puissance (10) comporte des ensembles actifs (42), dans lequel chaque ensemble actif (42) comprend une plaque de support (40, 40', 40"), et les plaques de support (40, 40', 40") des ensembles actifs (42, 42', 42") forment ensemble la première électrode principale (12),
**en ce que** chaque agencement en cercle (28, 28', 28") est divisé en segments de cercle par les ensembles actifs (42), dans lequel les composants semi-conducteurs de puissance (18) actifs du segment de cercle sont disposés sur la plaque de support (40) et la piste conductrice de commande (32) de l'agencement en cercle (28, 28', 28") respectif est divisée en segments de piste conductrice de commande (33, 33', 33") de l'agencement en cercle (28, 28', 28"), dans lequel l'électrode de commande (24) de chaque composant semi-conducteur de puissance (18) du segment de cercle respectif est reliée au segment de piste conductrice de commande (33, 33', 33') du segment de cercle respectif.

4. Module de semi-conducteurs de puissance selon la revendication 3, **caractérisé en ce que** les ensembles actifs (42) du module de semi-conducteurs de puissance (10) sont tous réalisés de la même manière.

5. Module de semi-conducteurs de puissance selon la revendication 3 ou 4, **caractérisé en ce que** le module de semi-conducteurs de puissance (1) présente un châssis (40) en matériau isolant dans lequel sont insérés les ensembles actifs (30).

6. Module de semi-conducteurs de puissance selon l'une des revendications 1 à 5, **caractérisé en ce que** les agencements en cercle ne se chevauchent pas ou sont exempts de chevauchement.

7. Module de semi-conducteurs de puissance selon l'une des revendications 1 à 6, **caractérisé en ce que** tous les composants semi-conducteurs de puissance (18) actifs sont disposés dans les agencements en cercle (28, 28', 28").

8. Module de semi-conducteurs de puissance selon la revendication 7, **caractérisé en ce que** chaque élément de contact (26) est réalisé sous la forme d'un contact à pression.

9. Module de semi-conducteurs de puissance selon l'une des revendications 1 à 8, **caractérisé en ce que** le module de semi-conducteurs de puissance présente un trou traversant central.
